# EUROPEAN PATENT APPLICATION

(11) **EP 1 037 271 A2**
(43) Date of publication of application: **20.09.2000**
(21) Application number: 00102132.8
(22) Date of filing: 07.02.2000
(51) Int. Cl.: H01L 21/316

(54) **Method for forming an interlayer insulating film, and semiconductor device**

(30) Priority: 17.03.1999 JP 7224199; 18.01.2000 JP 2000009418
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Maeda, Kazuo, Semiconductor Process Lab. Co., Ltd., Tokyo 108-0075 (JP)
(74) Representative: Schwabe - Sandmair - Marx

(57) **Abstract**

A method for forming an interlayer insulating film is disclosed. This method comprises the steps of: forming a first insulating film on an object to be formed, the film containing one selected from at least H₂O, C and a hydrocarbon; forming a first insulating film having porosity by performing heat treatment for the first insulating film to discharge H₂O, C or hydrocarbon therefrom; and forming a second insulating film on the first insulating film having porosity.

## Description

### BACKGROUND OF THE INVENTION

The present invention relates to a method for forming an interlayer insulating film and, more particularly, to a method for forming an interlayer insulating film having a low dielectric constant, which is necessary for a highly-integlated semiconductor device. A progress in high integlation regarding the semiconductor device in recent years has resulted in a narrower interval between wiring lines. As the narrowed interval between the wiring lines causes an increase in capacitance between the wiring lines, a request has been made for formation of an interlayer insulating film, which has a low dielectric constant.

With recent progresses in high integration of an LSI device, the wiring line has been micronized and multilayered. There has also been an increase in capacitance between the wiring lines. Such an increase in capacitance has caused a great reduction in an operating speed. Thus, improvement in this regard has been strongly demanded. As one of improvement measures, a method for reducing capacitance between the wiring lines has been studied. This method uses an interlayer insulating film, which has a dielectric constant lower than that of SiO₂ currently used for an interlayer insulating film.

Typical interlayer insulating films of low dielectric constants currently under study are ① an SiOF film, and ② an organic insulating film of a low dielectric constant. Description will now be made of these films.

### ① SiOF Film

An SiOF film is formed by using source gas containing F and substituting Si-F bond for a portion of Si-O bond in SiO₂. This SiOF film has a relative dielectric constant, which is monotonically reduced as concentration of F in the film increases.

For forming such SiOF films, several methods have been reported (see p.82 of monthly periodical "Semiconductor World", February issue of 1996). Most promising among these methods is one for forming an SiOF film by using SiH₄, O₂, Ar and SiF₄ as source gases, and by a high-density plasma enhanced CVD method (HDPCVD method). A relative dielectric constant of an SiOF film formed by this method is in a range of 3.1 to 4.0 (varies depending on F concentration in the film). This value is lower than a relative dielectric constant 4.0 of SiO₂, which has conventionally been used for the interlayer insulating film.

### ② Organic Insulating Film of Low Dielectric Constant

As an insulating film which has a lower dielectric constant (3.0 or lower) compared with the SiOF film, an organic insulating film of a low dielectric constant is now a focus of attention. Table 1 shows a few organic insulating films of low dielectric constants, which have been reported, and respective relative dielectric constants and thermal decomposition temperatures thereof.

**TABLE 1**

| Organic Insulating Film | Relative Dielectric Constant | Thermal Decomposition Temperature (°C) | Note |
|---|---|---|---|
| Fluorine-containing resin | 2.4 | 420 | p.82 of monthly periodical "Semiconductor World", February issue of 1997 |
| Cytop | 2.1 | 400 | p. 90 of monthly periodical "Semiconductor World", February issue of 1996 |
| Amorphous telon | 1.9 | 400 | p. 91 of monthly periodical "Semiconductor World", February issue of 1996 |

However, the SiOF film is disadvantageous in that an increase in concentration of F in the film leads to a reduction in moisture absorption resistance. The reduced moisture absorption resistance poses a serious problem, because a transistor characteristic and adhesion of an upper barrier metal layer are affected.

Peeling-off easily occurs in the organic insulating film of a low dielectric constant, because of bad adhesion with a silicon wafer or the SiO₂ film. Furthermore, the organic insulating film is disadvantageous in that heat resistivity is low since a thermal decomposition temperature is around 400 °C. The disadvantage of low heat resistivity poses a problem for annealing a wafer at a high temperature.

### SUMMARY OF THE INVENTION

It is an object of the present invention to provide a method for forming an interlayer insulating film of a low dielectric constant, which has good moisture absorption resistance and heat resistivity. It is another object of the invention to provide a semiconductor device, which employs the above method.

According to the method of the present invention for forming an interlayer insulating film, first, an SiO₂ film containing H₂O, C or hydrocarbon is formed on an object to be formed. Then, this SiO₂ film is subjected to plasma or vacuum annealing. The vacuum annealing is performed by heating the object to be formed in vacuum having pressure set equal to 0.1 Torr or lower. If pressure is 0.1 Torr or lower, a small quantity of N₂ Or Ar may be contained in atmosphere.

Then, by the annealing, gas contained in the SiO₂ film is discharged to the outside of the film, and the SiO₂ film becomes a porous SiO₂ film.

By experiment, the inventor confirmed that a dielectric constant of the porous SiO₂ film lies in a range of 2.0 to 3.0. This value is smaller than a dielectric constant 4.0 of a usual SiO₂ film having no porosity.

Since the porous SiO₂ film is formed by a usual chemical vapor deposition method, better heat resistivity is provided.

After formation of the porous SiO₂ film, a void surface can be made stable by performing H (hydrogen) plasma treatment for the SiO₂ film. In other words, by substituting Si-H bond for dangling bond in Si-O bond in the void surface, incursion of water from the void surface can be prevented.

Then, by forming a usual SiO₂ film on the porous SiO₂ film, incursion of water can be further prevented.

Secondly, according to the method of the present invention for forming an interlayer insulating film, a first film is formed in concavities on an object to be formed, which has concavities and convexities. A first insulating film is then formed on the first film. The first insulating film have an etching rate lower than that of the first film. Then, holes are bored in the first insulating film, and selective etching is performed for the first film through the hole to eliminate the same. Then, a second insulating film is formed on the first insulating film to close the hole formed in the first insulating film.

Then, a portion surrounded by the concavity of the object to be formed and the first and second insulating films becomes cavity. Accordingly, an interlayer insulating film having cavities is formed on the object to be formed. A dielectric constant of this interlayer insulating film having cavities is apparently lower than that when no cavities are provided. By experiment, the inventor confirmed that a dielectric constant of the interlayer insulating film having cavities was about 2.0. This value is lower than a dielectric constant 4.0 of a usual SiO₂ film having no cavities. In addition, since the cavities are surrounded by the object to be formed and the usual insulating film, no water incursion occurs in the cavity. In other words, the above process results in formation, on the object to be formed, an interlayer insulating film of a low dielectric constant, which has good moisture absorption resistance.

Thirdly, according to the method of the present invention for forming an interlayer insulating film, a first film is formed on an object to be formed. Then, patterning is performed for the first film to form a damascene trench, which reaches the object to be formed. Then, a first insulating film is formed on the first film, on a side portion of the damascene trench and bottom portion of the same. Anisotropic etching is then performed for the first insulating film to eliminate the first insulating film formed on the bottom portion of the damascene trench while leaving the same formed on the side portion of the damascene trench. Subsequently, a Cu-plated film is buried in the damascene trench. In this case, by the first insulating film formed previously in the side portion of the damascene trench, a component in the first film can be prevented from being dispersed in the Cu-plated film. Then, a barrier metal film is formed on the Cu-plated film. By this barrier metal film, a component in a film formed on the Cu-plated film can be prevented from being dispersed in the Cu-plated film. Then, a second insulating film is formed on the first film and the barrier metal film, and holes are bored. Thereafter, selective etching is performed for the first film through the hole to eliminate the same. Accordingly, a portion where the first film is formed becomes cavity. Then, a second insulating film is formed on the first insulating film to close the hole. This process results in formation of an interlayer insulating film having cavities on the object to be formed.

A dielectric constant of the interlayer insulating film having cavities formed in the above manner is apparently lower than that of an interlayer insulating film having no cavities. By experiment, the inventor confirmed that a dielectric constant of the interlayer insulating film having cavities was about 2.0. This value is lower than a dielectric constant 4.0 of a usual SiO₂ film having no cavities. Moreover, since the cavities are surrounded by the usual insulating film, no water incursion occurs in the cavity. In other words, the process results in formation, on the object to be formed, an interlayer insulating film of a low dielectric constant, which has good moisture absorption resistance.

### BRIEF DESCRIPTION OF THE DRAWINGS

FIGS. 1A to 1F are cross-sectional views showing a method for forming an interlayer insulating film according to a first embodiment of the present invention;
FIGS. 2A to 2F are cross-sectional views showing a method for forming an interlayer insulating film according to a second embodiment of the invention;
FIGS. 3A to 3F are cross-sectional views showing a method for forming an interlayer insulating film according to a third embodiment of the invention;
FIGS. 4A to 4F are cross-sectional views showing a method for forming an interlayer insulating film according to a fourth embodiment of the invention;
FIGS. 5A to 5H are cross-sectional views showing a method for forming an interlayer insulating film according to a fifth embodiment of the invention; and
FIGS. 6A to 6N are cross-sectional views showing a method for forming an interlayer insulating film according to a sixth embodiment of the invention.

### DESCRIPTION OF THE PREFERRED EMBODIMENTS

### (1) First Embodiment

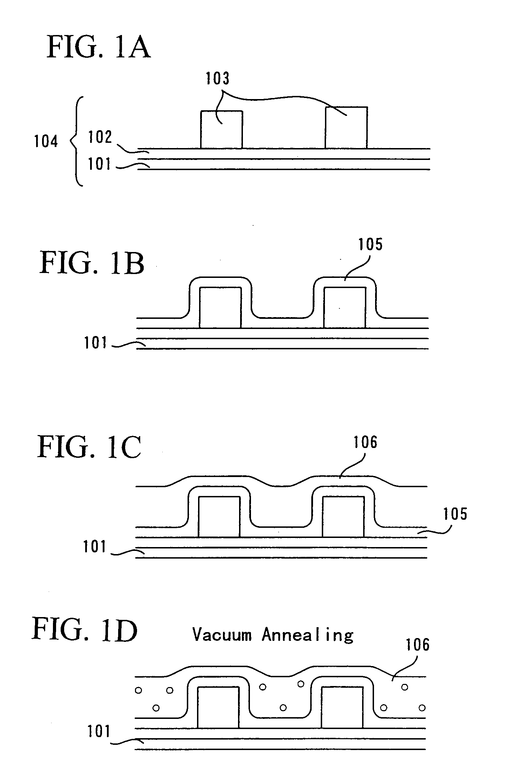

FIGS. 1A to 1F are cross-sectional views illustrating a first embodiment.

First, as shown in FIG. 1A, a BPSG (borophosphosilicate glass) film 102 is formed on a silicon substrate 101. Then, after an aluminium film is formed on the BPSG film 102, patterning is performed for the same to form an aluminum wiring layer 103. The silicon substrate 101, the BPSG film 102 and the aluminum wiring layer 103 constitute an object 104 to be formed.

Then, as shown in FIG. 1B, an SiO₂ film 105 is formed on the object 104 to be formed. This SiO₂ film 105 is formed by using SiH₄ and N₂O as source gases while keeping the silicon substrate 101 at 400 °C and by a CVD method (chemical vapor deposition method). The SiO₂ film 105 can prevent H₂O from being dispersed in the aluminum wiring layer 103.

Subsequently, as shown in FIG. 1C, an SiO₂ film 106 is formed on the SiO₂ film 105. This SiO₂ film 106 is formed by using TEOS (tetraethoxysinane), O₂ and a small quantity of H₂O as source gases while keeping the silicon substrate 101 at 100 °C, applying an RF power having a frequency of 13.56 MHz, and using a plasma enhanced CVD method at pressure of 1 Torr. Flow rates of source gases at this tine are 30∼50 sccm, 100∼ 600sccm and 50∼60sccm respectively for TEOS, O₂ and H₂O. In this case, the use of the small quantity of H₂O as source gas results in inclusion of OH radical and small quantity of H₂O in the SiO₂ film 106. It should be noted that TMS(trimethylsilane)is also used instead of the TEOS. The flow rate of the TMS is 30∼50 sccm.

Then, as shown in FIG. 1D, vacuum annealing is performed for the SiO₂ film 106 at pressure of 0.1 Torr while keeping the silicon substrate 101 at 400 °C. The vacuum annealing is defined an annealing that is performed in an atmosphere of reduced pressure. After completing the annealing, OH radical and H₂O contained in the SiO₂ film 106 are discharged from the film, and a number of voids are formed therein.

Instead of performing the aforementioned vacuum annealing, a plasma annealing may also be performed for the SiO₂ film 106. The plasma annealing is defined an annealing that is performed in a plasmanized atmosphere. In the present embodiment, RF power is applied to the atmosphere via an upper electrode (not shown) and a lower electrode (not shown) so as to plasmanize the atmosphere. And the process condition of the plasma annealing is as follows: RF power having frequency of 13.56 MHz and power of 100 W is applied to the upper electrode, RF power having frequency of 400 kHz and power of 400 W is applied to the lower electrode, pressure is 0.2 Torr, temperature is 400°C, time for annealing is 60 ∼120 sec, and O₂ is contained in the atmosphere with flow rate of 600 sccm.

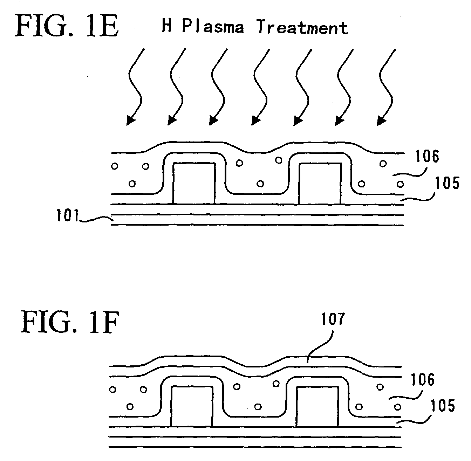

Then, as shown in FIG. 1E, H (hydrogen) plasma treatment is performed for the SiO₂ film 106. The H (hydrogen) plasma is generated by applying RF power to H (hydrogen) containing atmosphere via the upper electrode (not shown) and the lower electrode (not shown). In the present embodiment the RF power applied to the upper electrode has frequency of 13.56 MHz and power of 50 W, and the RF power applied to the lower electrode has frequency of 400kHz and power of 400W. Further, the pressure of the H containing atmosphere is 0.1∼0.2 Torr, the flow rate of H is 600 sccm, and the time for the H plasma treatment is 60 sec. During undergoing the H plasma treatment the temperature of the silicon substrate 101 is maintained at 400 °C.

At this time, plasma H atoms enter the number of voids formed in the SiO₂ film 106, and SiH bond is formed on the surface of the voids by the H atoms and Si atoms on the surface of the same. Accordingly, the surface of the voids become stable, and incursion of water into the SiO₂ film 106 can be slowed down until a next process. Also, since the inside of the voids are filled with H₂ molecules, which have no dipole moment, a dielectric constant of the SiO₂ film 106 is 3.0 or lower. This value is smaller than a dielectric constant 4.0 of a usual SiO₂ film.

In the H (hydrogen) plasma treatment, the plan H atoms do not enter the SiO₂ film 105 formed below the SiO₂ film 106 so deeply. Accordingly, the H atoms can be prevented form affecting the object 104 to be formed below the SiO₂ film 105.

Then, as shown in FIG. 1F, an SiO₂ film 107 is formed on the SiO₂ film 106. This SiO₂ film 107 is formed by a CVD method, which contains SiH₄ and N₂O as source gases, while keeping the silicon substrate 101 at 400 °C. By the SiO₂ film 107, incursion of water into the previously formed SiO₂ film 106 having porosity can be prevented, and the H₂ atoms filling the inside of the voids of the SiO₂ film 106 can be prevented from being discharged from the film.

The foregoing process of forming the SiO₂ films 105, 106 and 107 results in formation of an interlayer insulating film of a low dielectric constant on the object 104 to be formed. In other words, since the SiO₂ film 106 has porosity and the inside of the voids are filled with H₂ molecules having no dipole moment, a dielectric constant thereof is smaller than that of a usual SiO₂ film. Also, the SiO₂ films 107 and 105 are formed on and below SiO₂ film 106, respectively. These films can prevent incursion of water into the porous SiO₂ film 106, and the H₂ molecules inside the voids from being discharged from the film.

### (2) Second Embodiment

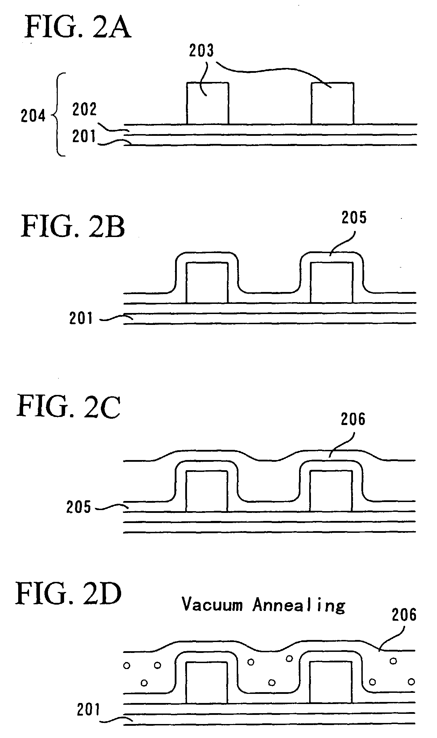

FIGS. 2A to 2F are cross-sectional views illustrating the second embodiment.

The second embodiment is different from the first embodiment in that SiH₄ is used as source gas instead of TEOS for forming a porous SiO₂ film.

First, as shown in FIG. 2A, a BPSG (borophosphosilicate glass) film 202 is formed on a silicon substrate 201. After an aluminum layer is formed on the BPSG film 202, patterning is performed for the same to form an aluminum wiring layer 203. Then, the silicon substrate 201, the BPSG film 202 and the aluminum wiring layer 203 constitute an object 204 to be formed.

Then, as shown in FIG. 2B, an SiO₂ film 205 is formed on the object 204 to be formed. This SiO₂ film 205 is formed by a CVD method (chemical vapor deposition method), which employs SiH₄ and N₂O as source gases, while keeping the silicon substrate 201 at 400 °C. The SiO₂ film 205 can prevent H2O from dispersing in the aluminum wiring layer 203.

Subsequently, as shown in FIG. 2C, an SiO₂ film 206 is formed on the SiO₂ film 205. This SiO₂ film 206 is formed by a CVD method, which employs SiH₄, O₂ and a small quantity of H₂O as source gases, while keeping the silicon substrate 201 at 100 °C, and at pressure of 3 Torr. Flow rates of source gases at this tine are 30∼50 sccm, 90∼100 sccm, 30∼50 sccm and 200 ∼600 sccm respectively for SiH₄, O₂, H₂O and Ar. In this case, the use of the small quantity of H₂O as source gas results in inclusion of small quantity of H₂O in the SiO₂ film 206.

Then, as shown in FIG. 2D, vacuum annealing is performed for SiO₂ film 206 by keeping the silicon substrate 201 at 400 °C and at pressure of 0.1 Torr. Accordingly, H₂O contained in the SiO₂ film 206 is discharged therefrom, and a number of voids are formed therein.

Instead of performing the vacuum annealing, a plasma annealing may also be performed for the SiO₂ film 206. In the present embodiment, RF power is applied to the atmosphere via an upper electrode (not shown) and a lower electrode (not shown) so as to plasmanize the atmosphere. And the process condition of the plasma annealing is as follows: RF power having frequency of 13.56 MHz and power of 100 W is applied to the upper electrode, RF power having frequency of 400 kHz and power of 400 W is applied to the lower electrode, pressure is 0.2 Torr, temperature is 400°C, time for annealing is 60 ∼120 sec, and O₂ is contained in the atmosphere with flow rate of 600 sccm.

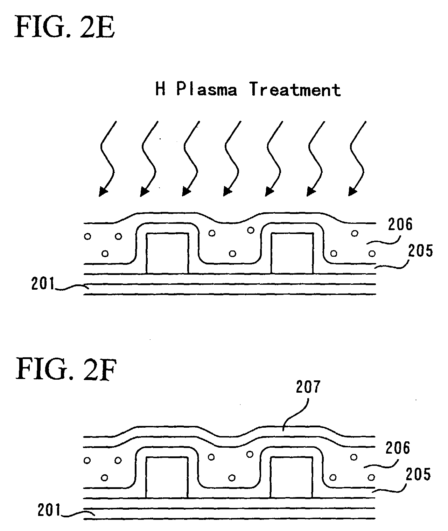

Then, as shown in FIG. 2E, H (hydrogen) plasma treatment is performed for the SiO₂ film 206 in the same way as the first embodiment. That is, the H (hydrogen) plasma is generated by applying RF power to H (hydrogen) containing atmosphere via the upper electrode (not shown) and the lower electrode (not shown). The RF power applied to the upper electrode has frequency of 13.56 MHz and power of 50 W, and the RF power applied to the lower electrode has frequency of 400kHz and power of 400W. Further, the pressure of the H containing atmosphere is 0.1∼0.2 Torr, the flow rate of H is 600 sccm, and the time for the H plasma treatment is 60 sec. During undergoing the H plasma treatment the temperature of the silicon substrate 201 is maintained at 400 °C.

At this time, plasma H atoms enter the number of voids. Formed in the SiO₂ film 206. By the H atoms and Si atoms on the surface of the voids, an Si-H bond is formed on the surface of the same. Accordingly, the surface of the voids are stablized, and incursion of water into the SiO₂ film 206 can be slowed down until a next process. Also, since the inside of the voids are filled with H₂ molecules having no dipole moment, a dielectric constant of the SiO₂ film 206 lies in a range of 2.0 to 3.0, which is smaller than a dielectric constant 4.0 of a usual SiO₂ film.

In the H (hydrogen) plasma treatment, the plasma H atoms do not enter the SiO₂ film 205 formed below the SiO₂ film 206 so deeply. Accordingly, the H atoms can be prevented from affecting the object 204 formed below the SiO₂ film 205.

Then, as shown in FIG. 2F, an SiO₂ film 207 is formed on the SiO₂ film 206. This SiO₂ film 207 is formed by a CVD method, which contains SiH₄ and N₂O in source gases, while keeping the silicon substrate 201 at 400 °C. By the SiO₂ film 207, incursion of water into the previously formed SiO₂ film 206 having porosity can be prevented, and H₂O molecules filling the inside of the voids of the SiO₂ film 206 can be prevented from being discharged to the outside of the film.

As in the case of the first embodiment, the foregoing process of forming the SiO₂ films 205, 206 and 207 results in formation of an interlayer insulating film of a low dielectric constant on the object 204 to be formed. In other words, since the SiO₂ film 206 has porosity and the inside of the voids are filled with H₂ molecules having no dipole moment, a dielectric constant of the SiO₂ film 206 is smaller than that of a usual SiO₂ film. Also, the usual SiO₂ films 205 and 207 are formed below and on the SiO₂ film 206. Accordingly, incursion of water into the porous SiO₂ film 206 can be prevented, and H₂ molecules inside the voids can be prevented from being discharged to the outside of the film.

### (3) Third Embodiment

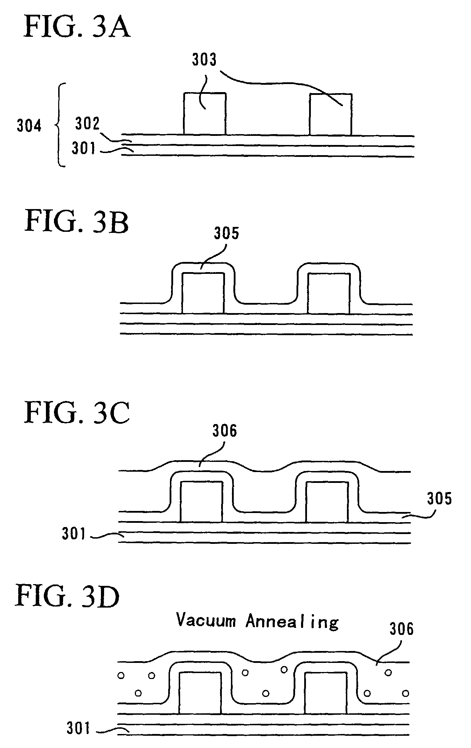

FIGS. 3A to 3F are cross-sectional views illustrating a third embodiment.

The third embodiment is different from the first and second embodiments in that for forming a porous insulating film, B₂H₆ is used as source gas.

First, as shown in FIG. 3A, a BPSG (borophosphosilicate glass) film 302 is formed on a silicon substrate 301. Then, after an aluminum film is formed thereon, patterning is performed for the same to form an aluminum wiring layer 303. The silicon substrate 301, the BPSG film 302 and the aluminum wiring layer 303 constitute an object 304 to be formed.

Then, as shown in FIG. 3B, an SiO₂ film 305 is formed on the object 304 to be formed. This SiO₂ film 305 is formed by a CVD method (chemical vapor deposition method), which contains SiH₄ and N₂O as source gases, while keeping the silicon substrate 301 at 400 °C. The SiO₂ film 305 can prevent H2O from dispersing in the aluminum wiring layer 203.

Then, as shown in FIG. 3C, a B (boron)-containing SiO₂ film 306 is formed on the SiO₂ film 305. This SiO₂ film 306 is formed by using SiH₄, O₂ and B₂H₆ as source gases while keeping the silicon substrate 301 at 100 °C, applying an RF power having a frequency of 13.56 MHz, and by a plasma enhanced CVD method at source gas pressure of 1 Torr. Flow rates of source gases at this time are 30∼50 sccm, 120 sccm and 24∼30 sccm respectively for SiH₄, O₂ and B₂H₆. N₂O with flow rate of 1000 sccm can also be contained in the source gases. During the formation of the film 305, O₂ of the source gas and H contained in SiH₄ or B₂H₆ generate H₂O. Accordingly, the B (boron)-containing SiO₂ film 306 contains a small quantity of H₂O.

Then, as shown in FIG. 3D, vacuum annealing is performed for the SiO₂ film 306 by keeping the silicon substrate 301 at 400 °C and at pressure of 0.1 Torr. Accordingly, H₂O and B (boron) contained in the SiO₂ film 306 are discharged from the film, and a number of voids are formed therein.

Instead of performing the vacuum annealing, a plasma annealing may also be performed for the SiO₂ film 306. In the present embodiment, RF power is applied to the atmosphere via an upper electrode (not shown) and a lower electrode (not shown) so as to plasmanize the atmosphere. And the process condition of the plasma annealing is as follows: RF power having frequency of 13.56 MHz and power of 100 W is applied to the upper electrode, RF power having frequency of 400 kHz and power of 400 W is applied to the lower electrode, pressure is 0.2 Torr, temperature is 400°C, time for annealing is 60 ∼120 sec, and O₂ is contained in the atmosphere with flow rate of 600 sccm.

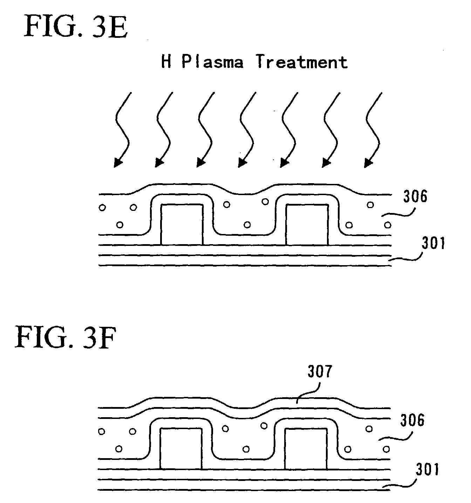

Then, as shown in FIG. 3E, H (hydrogen) plasma treatment is performed for the SiO₂ film 306 in the same way as the first and second embodiments. That is, the H (hydrogen) plasma is generated by applying RF power to H (hydrogen) containing atmosphere via the upper electrode (not shown) and the lower electrode (not shown). The RF power applied to the upper electrode has frequency of 13.56 MHz and power of 50 W, and the RF power applied to the lower electrode has frequency of 400kHz and power of 400W. Further, the pressure of the H containing atmosphere is 0.1∼0.2 Torr, the flow rate of H is 600 sccm, and the time for the H plasma treatment is 60 sec. During undergoing the H plasma treatment the temperature of the silicon substrate 301 is maintained at 400 °C.

At this tine, plasma H atoms enter a large number of voids formed in the SiO₂ film 306. By the H atoms and Si atoms on the surface of the voids, Si-H bond is formed on the surface of the voids. Accordingly, the surface of the voids are stablized, and incursion of water into the SiO₂ film 306 can be slowed down until a next process. Also, since the inside of the voids are filled with H₂ molecules having no dipole moment, a dielectric constant of the SiO₂ film 306 is lies in a range of 2.0 to 3.0, which is smaller than a dielectric constant 4.0 of a usual SiO₂ film.

Then, as shown in FIG. 3F, an SiO₂ film 307 is formed on the SiO₂ film 306. This SiO₂ film 307 is formed by a CVD method, which contains SiH₄ and N₂O as source gases, while keeping the silicon substrate 301 at 400 °C. By the SiO₂ film 307, incursion of water into the previously formed SiO₂ film 306 having porosity can be prevented, and H₂ filling the inside of the voids of the SiO₂ film 305 can be prevented from being discharged to the outside of the film.

The foregoing process of forming the SiO₂ films 305, 306 and 307 results in formation of an interlayer insulating film of a low dielectric constant on the object 304 to be formed. In other words, since the SiO₂ film 306 has porosity and the inside of the voids are filled with H₂ molecules having no dipole moment, a dielectric constant of the SiO₂ film 306 is smaller than that of a usual SiO₂ film. Also, the SiO₂ film 307 is formed on the SiO₂ film 306. Since this film 307 is a usual SiO₂ film, incursion of water into the SiO₂ film 306 with porosity can be prevented, and H₂ molecules in the voids can be prevented from being discharged to the outside of the film.

### (4) Fourth Embodiment

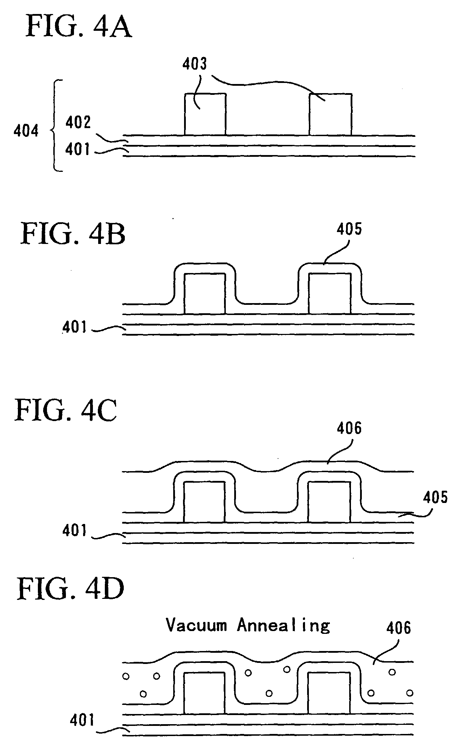

FIGS. 4A to 4F are cross-sectional views illustrating the fourth embodiment.

A fourth embodiment is different from the first to third embodiments in that C₂F₆ is used as source gas for forming a porous SiO₂ film.

First, as shown in FIG. 4A, a BPSG (borophosphosilicate glass) film 402 is formed on a silicon substrate 401. Then, after an aluminum film is formed thereon, patterning is performed for the same to form an aluminum wiring layer 403. The silicon substrate 401, the BPSG film 402 and the aluminum wiring layer 403 constitute an object 404 to be formed.

Then, as shown in FIG. 4B, an SiO₂ film 405 is formed on the object 404 to be formed. This SiO₂ film 405 is formed by a CVD method (chemical vapor deposition method), which contains SiH₄ and N₂O as source gases, while keeping the silicon substrate 401 at 400 °C. The SiO₂ film 405 can prevent H₂O from dispersing in the aluminum wiring layer 403.

Subsequently, as shown in FIG. 4C, an F (fluorine)-containing SiO₂ film 406, which will later be a porous insulating film, is formed on the SiO₂ film 405. This SiO₂ film 406 is formed by using TEOS (tetraethoxysinane), O₂ and C₂F₆ as source gases while keeping the silicon substrate 401 at 100 °C, applying an RF power having a frequency of 13.56 MHz, and by a plasma enhanced CVD method at source gas pressure of 1 Torr. Flow rates of source gases at this time are 30∼50 scan, 600 sccm and 40∼60 sccm respectively for TEOS, O₂ and C₂F₆. N₂O with flow rate of 1000 sccm can also be contained in the source gases. During the formation of the film 406, O₂ of the source gas and C contained in TEOS or C2F6 generate hydrocarbon, and O₂ of the source gas and H contained in TEOS generate H₂O. Accordingly, the SiO₂ film 406 contains hydrocarbon and H₂O. It should be noted that TMS(trimethylsilane) is also used instead of the TEOS. The flow rate of the TMS is 30∼50 sccm.

Then, as shown in FIG. 4D, vacuum annealing is performed for the SiO₂ film 406 by keeping the silicon substrate 401 at 400 °C and at pressure of 0.1 Torr. Accordingly, hydrocarbon, H₂O and F (fluorine) containing in the SiO₂ film 406 are discharged from the film, and a number of voids are formed therein.

Instead of performing the vacuum annealing, a plasma annealing may also be performed for the SiO₂ film 406. In the present embodiment, RF power is applied to the atmosphere via an upper electrode (not shown) and a lower electrode (not shown) so as to plasmanize the atmosphere. And the process condition of the plasma annealing is as follows: RF power having frequency of 13.56 MHz and power of 100 W is applied to the upper electrode, RF power having frequency of 400 kHz and power of 400 W is applied to the lower electrode, pressure is 0.2 Torr, temperature is 400°C, time for annealing is 60∼120 sec, and O₂ is contained in the atmosphere with flow rate of 600 sccm.

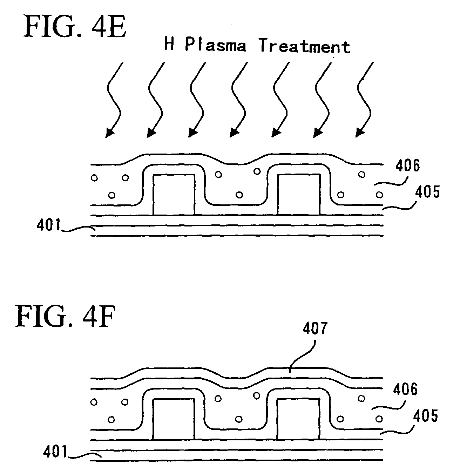

Then, as shown in FIG. 4E, H (hydrogen) plasma treatment is performed for the SiO₂ film 406 in the same way as the first to third embodiments. That is, the H (hydrogen) plasma is generated by applying RF power to H (hydrogen) containing atmosphere via the upper electrode (not shown) and the lower electrode (not shown). The RF power applied to the upper electrode has frequency of 13.56 MHz and power of 50 W, and the RF power applied to the lower electrode has frequency of 400kHz and power of 400W. Further, the pressure of the H containing atmosphere is 0.1∼0.2 Torr, the flow rate of H is 600 sccm, and the tine for the H plasma treatment is 60 sec. During undergoing the H plasma treatment the temperature of the silicon substrate 301 is maintained at 400 °C.

At this time, plasma H atoms enter a large number of voids formed in the SiO₂ film 406. By the H atoms and Si atoms on the surface of the voids, Si-H bond is formed on the surface of the voids. Accordingly, the surface of the voids are stablized, and incursion of water into the SiO₂ film 406 can be slowed down until a next process. Also, since the inside of the voids are filled with H₂ molecules having no dipole moment, a dielectric constant of the SiO₂ film 406 lies in a range of 2.0 to 3.0, which is smaller than a dielectric constant 4.0 of a usual SiO₂ film.

In the H (hydrogen) plasma treatment, the plasma H atoms do not enter the SiO₂ film 405 formed below the SiO₂ film 406 so deeply. Thus, the H atoms can be prevented from affecting the object 404 to be formed below the SiO₂ film 405.

Then, as shown in FIG. 4F, an SiO₂ film 407 is formed on the SiO₂ film 406. This SiO₂ film 407 is formed by a CVD method, which contains SiH₄ and N₂O as source gases, while keeping the silicon substrate 401 at 400 °C. By the SiO₂ film 407, incursion of water into the previously formed SiO₂ film 406 having porosity can be prevented, and H₂ molecules filling the inside of the voids of the SiO₂ film 406 can be prevented from being discharged to the outside of the film.

The foregoing process of forming the SiO₂ films 405, 406 and 407 results in formation of an interlayer insulating film of a low dielectric constant on the object 404 to be formed. In other words, since the SiO₂ film 406 has porosity and the inside of the voids are filled with H₂ molecules having no dipole moment, a dielectric constant of the SiO₂ film 406 is smaller than that of a usual SiO₂ film. Also, The usual SiO₂ films 405 and 407 are formed below and on the SiO₂ film 406. By these films, incursion of water into the porous SiO₂ film 406 can be prevented, and H₂ molecules inside the voids can be prevented from being discharged to the outside of the film.

### (5) Fifth Embodiment

FIGS. 5A to 5H are cross-sectional views illustrating the fifth embodiment.

According to the fifth embodiment, a photoresist is buried in an object to be formed and, by performing ashing for the same, cavities are formed in an interlayer insulating film. Detailed description will be made of this process below.

First, as shown in FIG. 5A, a BPSG (borophosphosilicate glass) film 502 is formed on a silicon substrate 501. Then, after an aluminum film is formed thereon, patterning is performed for the same to form an aluminum wiring layer 503. The silicon substrate 501, the BPSG film 502 and the aluminum wiring layer 503 constitute an object 504 to be formed.

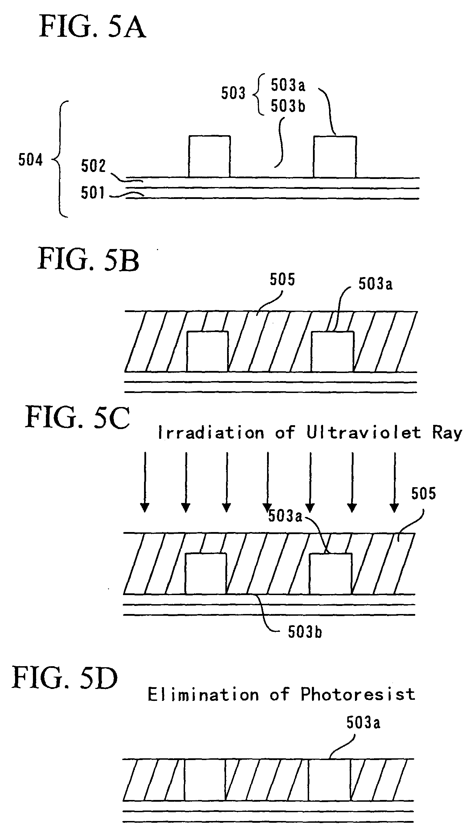

Then, as shown in FIG. 5B, a photoresist 505 is coated on the object 504 to be formed so as to cover a convexity 503a of the wiring layer. The photoresist covering the convexity 503a of the wiring layer will be eliminated later. Thus, the photoresist 505 should be coated to have a thickness, which facilitates the elimination.

Then, as shown in FIG. 5C, the photoresist 505 is irradiated uniformly with ultraviolet ray of ion intensity. Regarding ultraviolet ray to be radiated at this time, ultraviolet ray having low intensity should be used, which allow only the photoresist covering the convexity 503a of the wiring layer to be eliminated, but not the photoresist in a concavity 503b of the wiring layer in the following step.

Subsequently, as shown in FIG. 5D, the photoresist covering the convexity 503a of the wiring layer is developed and eliminated.

Then, as shown in FIG. 5E, an SiO₂ film 506 is formed on the convexity 503a of the wiring layer and the remaining photoresist 505 by a plasma enhanced CVD method (chemical vapor deposition method). Accordingly, the photoresist 505 is confined between the concavity 503b of the wiring layer and the SiO₂ film 506.

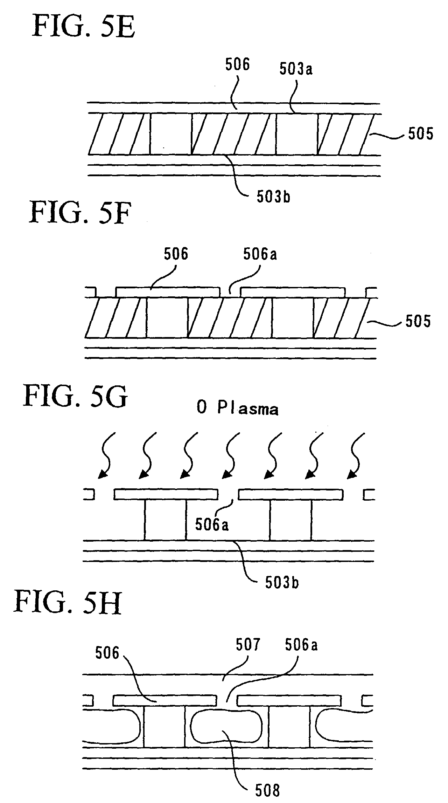

Then, as shown in FIG. 5F, a hole 506a is formed in the SiO₂ film 506 formed on the remaining photoresist 505. This hole 506a will be used later for ashing the confined photoresist 505. After ashing, the hole will be closed by another SiO₂ film. Thus, a diameter of the hole should be set small enough for closing later.

Subsequently, as shown in FIG. 5G, ashing is performed for the photoresist 505 confined between the concavity 503b of the wiring layer and the SiO₂ film 506 by O plasma and through the hole 506a.

Then, as shown in FIG. 5H, an SiO₂ film 507 having a film thickness of 300 nm is formed on the SiO₂ film 506 by a plasma enhanced CVD method. Accordingly, the hole 506a is closed, and a cavity 508 is formed in an area surrounded by the concavity 503b of the wiring layer and the SiO₂ films 506 and 507.

The foregoing process results in formation of an interlayer insulating film of SiO₂ having cavities on the object 504 to be formed. This interlayer insulating film has a dielectric constant smaller than that of an interlayer insulating film of a usual SiO₂ film. In other words, since a dielectric constant of the cavity portion is smaller than that of SiO₂, a dielectric constant of the entire film is about 2.0, which is smaller than a dielectric constant 4.0 with no cavities.

### (6) Sixth Embodiment

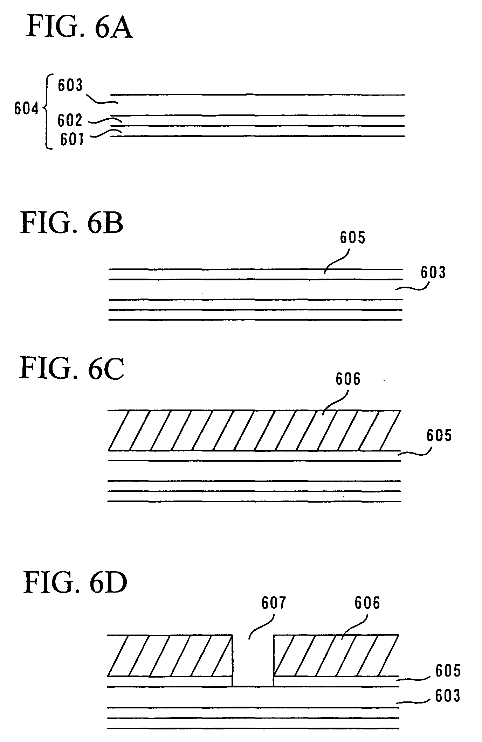

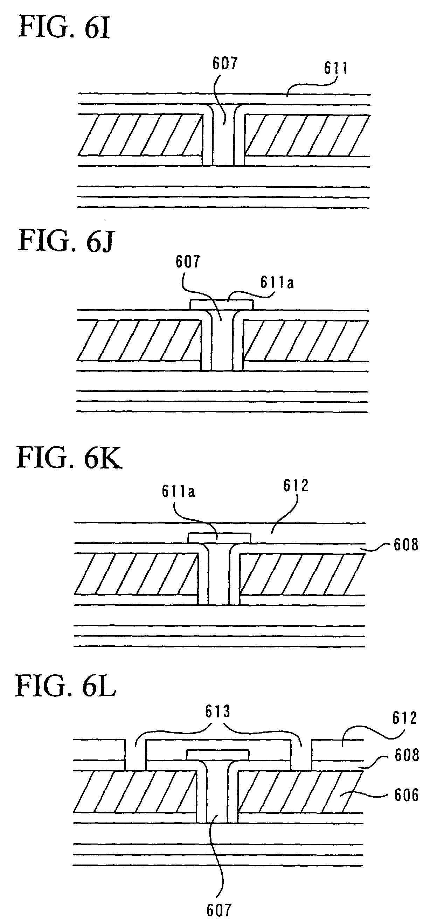

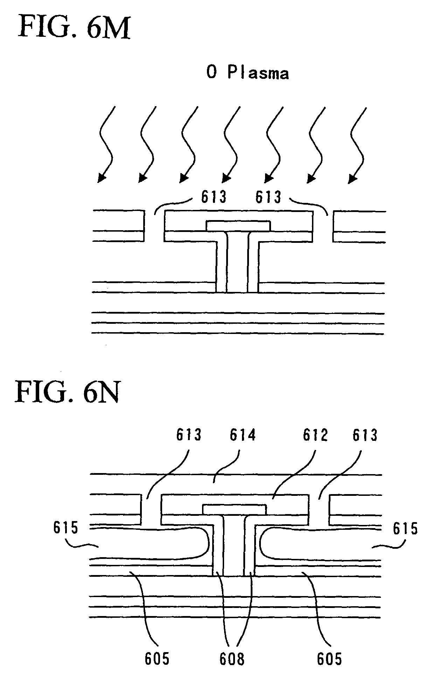

FIGS. 6A to 6N are cross-sectional views illustrating a sixth embodiment. The sixth embodiment is a case of applying the fifth embodiment to a damascene process.

First, as shown in FIG. 6A, a BPSG (borophosphosilicate glass) film 602 is formed on a silicon substrate 601. Then, after an aluminum layer is formed thereon, patterning is performed for the same to form an aluminum wiring layer 603. It should be noted that aluminum wiring layer 603 in figures is not patterned for convenience. The silicon substrate 601, the BPSG film 602 and the aluminum wiring layer 603 constituted an object 604 to be formed.

Then, as shown in FIG. 6B, an SiO₂ film 605 having a film thickness of 50 nm is formed on the aluminum wiring layer 603 by a CVD method (chemical vapor deposition method).

Subsequently, as shown in FIG. 6C, a polyimide film 606 having a film thickness of 500 nm is formed on the SiO₂ film 605. This polyimide film 606 will be subjected to ashing later as in the case of the fifth embodiment, and used for forming cavities in an insulating film.

Then, as shown in FIG. 6D, patterning is performed for the SiO₂ film 605 and the polyimide film 606 to form a damascene trench 607 reaching the aluminum wiring layer 603.

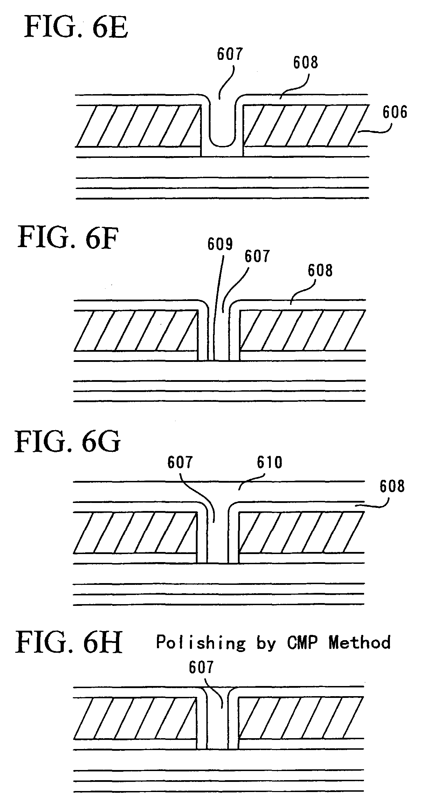

Subsequently, as shown in FIG. 6E, an SiO₂ film 608 having a film thickness of 100 nm is formed on the polyimide film 606 by a plasma enhanced CVD method. In this case, the SiO₂ film 608 is also formed on the side and bottom portions of the damascene trench 607.

Then, as shown in FIG. 6F, anisotropic etching is performed for the SiO₂ film 608. Accordingly, the SiO₂ film 608 formed on the bottom portion of the damascene trench 607 is eliminated, and a contact hole 609 reaching the alminum wiring layer 603 is formed. In this case, the SiO₂ film 608 formed in the side portion of the damascene trench 607 is left without being eliminated.

Then, as shown in FIG. 6G, a Cu-plated film 610 is formed on the SiO₂ film 608 and in the damascene trench 607. The Cu-plated film in the damascene trench 607 is used as a Cu wiring line.

Then, as shown in FIG. 6H, the Cu-plated film 610 is polished by a CMP method (chemical mechanical polishing method), and superfluous Cu formed on the SiO₂ film 608 is eliminated. Accordingly, Cu is left only in the damascene trench 607.

Then, as shown in FIG. 6I, a barrier metal TiN film 611 is formed above the damascene trench 607. Accordingly, Cu in the damascene trench 607 can be prevented from being dispersed in an SiO₂ film formed later above the damascene trench 607.

Subsequently, as shown in FIG. 6J, patterning is performed to leave a TiN film 611a formed above the damascene trench 607, and the TiN film 611 formed in the other portions is etched to be eliminated.

Then, as shown in FIG. 6K, an SiO₂ film 612 having a film thickness of 100 nm is formed on the SiO₂ film 608 and the TiN film 611a by a plasma enhanced CVD method.

Then, as shown in FIG. 6L, patterning is performed for the SiO₂ film 608 and the SiO₂ film 612 formed thereon to bore holes 613 which are used for ashing the polyimide film 606. Thus, the holes 613 should be formed in an area other than a portion above the damascene trench 607, i.e., in an area where the polyimide film 606 remains, and a hole diameter should be set small enough for closing later.

Subsequently, as shown in FIG. 6M, ashing is performed for the polyimide film 606 by O plasma through the hole 613.

Then, as shown in FIG. 6N, an SiO₂ film 614 having a film thickness of 400 nm is formed on the SiO₂ film 612 by a plasma enhanced CVD method. This SiO₂ film 614 is used for closing the hole 613. Accordingly, a cavity 615 is formed in an area surrounded by the SiO₂ films 605, 608 and 614.

The foregoing process results in formation of an interlayer insulating film of SiO₂ having cavities on the object 604 to be formed. This interlayer insulating film has a dielectric constant, which is smaller than that of the interlayer insulating film of usual SiO₂. In other words, since a dielectric constant of the cavity portion is smaller than that of SiO₂, a dielectric constant of the entire film is about 2.0, which is smaller than a dielectric constant 4.0 with no cavities.

## Claims

1. A method for forming an interlayer insulating film, comprising the steps of:
forming a first insulating film (106,206,306,406) on an object (104,204,304,404) to be formed, said film (106,206,306,406) containing one selected from at least H₂O, C and hydrocarbon:
forming a first insulating film having porosity (106,206,306,406) by performing heat treatment for said first insulating film (106,206,306,406) to discharge one selected from H₂O, C and hydrocarbon therefrom; and
forming a second insulating film (107,207,307,407) on said first insulating film having porosity (106,206,306,406).

2. A method according to claim 1, wherein said heat treatment is performed by plasma annealing.

3. A method according to claim 1, wherein said heat treatment is performed by vacuum annealing.

4. A method according to any one of claims 1 to 3, wherein said first insulating film (106,206,306,406) is formed by a plasma enhanced chemical vapor deposition, which uses Si-containing organic compound gas, O₂ and H₂O as source gases.

5. A method according to any one of claims 1 to 3, wherein said first insulating film (106,206,306,406) is formed by a plasma enhanced chemical vapor deposition, which uses Si-containing organic compound gas, O₂ and CF containing gas as source gases.

6. A method according to claim 4, wherein said Si-containing organic compound gas is one selected from TEOS and TMS.

7. A method according to claim 5, wherein said Si-containing organic compound gas is TEOS, and said CF-containing gas is C₂F₆.

8. A method according to any one of claims 1 to 3, wherein said first insulating film (106,206,306,406) is formed by a plasma enhanced chemical vapor deposition, which uses SiH₄-containing gas, O₂ and H₂O as source gases.

9. A method according to any one of claims 1 to 3, wherein said first insulating film (106,206,306,406) is formed by a plasma enhanced chemical vapor deposition, which uses SiH₄-containing gas, O₂ and B (boron) containing gas as source gases.

10. A method according to claim 8, wherein said SiH₄-containing gas is one selected from SiH₄ and SiH₃ (CH₃).

11. A method according to claim 9, wherein said SiH4-containing gas is one selected from SiH₄ and SiH₃ (CH₃), and said B (boron)-containing gas is B₂H₆

12. A method according to claim 1, wherein after said first insulating film having porosity (106,206,306,406) is formed, H (hydrogen) plasma treatment is performed for the same.

13. A method for forming an interlayer insulating film, comprising the steps of:
forming a film (505) on an object (504) to be formed having concavities (503b) and convexities (503a), said film (505) being provided for forming cavities (508);
leaving said film (505) for forming cavities (508) in the concavities (503b) of said object (504) to be formed;
forming a first insulating film (506) on said film (505) for forming cavities (508), said insulating film (506) having an etching rate lower than that of said film (505) for forming cavities (508);
boring holes (506a) in said first insulating film (506);
making the concavities (503b) of said object (504) to be formed cavities (508) by etching said film (505) for forming cavities (508) selectively through said holes (506a); and
forming a second insulating film (507) on said first insulating film (506) to close said holes (506a).

14. A method for forming an interlayer insulating film, comprising the steps of:
forming a film (606) on an object (604) to be formed, said film (606) being provided for forming cavities (615);
performing patterning for said film (606) for forming cavities (615) to form damascene trenches (607) that reach said object (604) to be formed;
forming a first insulating film (608) on said film (606) for forming cavities (615), on a side and a bottom portion of said damascene trenches (607);
performing anisotropic etching for said first insulating film (608) to eliminate the same formed on the bottom portion of said damascene trenches (607) while leaving the same formed on the side portion of said damascene trenches (607);
burying a Cu-plated film (610) in said damascene trenches (607);
forming a barrier metal film (611a) on said Cu-plated film (610);
forming a second insulating film (612) above said film (606) for forming cavities (615) and on said barrier metal film (611a);
boring holes (613) in said second insulating film (612);
making the portion where said film (606) for forming cavities (615) are formed be cavities (615) by performing selective etching for said film (606) for forming cavities (615) through said holes (613) to eliminate the same; and
forming a third insulating film (614) on said second insulating film (612) to close said holes (613).

15. A semiconductor device having an interlayer insulating film, which is formed by a method according to any one of clams 1, 13 and 14.
